# FASCICULE DE BREVET EUROPEEN

(11) **EP 3 159 916 B1**
(45) Date de publication et mention de la délivrance du brevet: **26.08.2020**
(21) Numéro de dépôt: 16195113.2
(22) Date de dépôt: 21.10.2016
(51) Int. Cl.: H01L 21/304, H01L 21/683

(54) **PROCÉDÉ D AMINCISSEMENT D ÉCHANTILLONS**
VERFAHREN ZUR VERDÜNNUNG VON PROBEN
METHOD FOR THINNING SAMPLES

(30) Priorité: 23.10.2015 FR 1560141
(43) Date de publication de la demande: 26.04.2017
(73) Titulaire: COMMISSARIAT À L'ÉNERGIE ATOMIQUE ET AUX ÉNERGIES ALTERNATIVES, 75015 Paris (FR)
(72) Inventeur: DECHAMP, Jérôme, 38140 BEAUCROISSANT (FR); MORICEAU, Hubert, 38120 SAINT-EGREVE (FR); ZUSSY, Marc, 38120 SAINT EGREVE (FR)
(74) Mandataire: Delorme, Nicolas

(56) Documents cités:
- EP-A1- 2 339 617
- US-A- 6 013 534
- US-A- 6 017 822
- US-A1- 2010 092 718
- US-A1- 2012 295 400

## Description

La présente invention propose un procédé d'amincissement d'échantillons pour des applications dans un domaine utilisant des techniques de micro-électroniques, l'échantillon pouvant être un substrat constitué par exemple d'un matériau semi-conducteur, ou un composant électronique, telle qu'une puce.

Dans le domaine de l'amincissement des puces, le procédé DBG (acronyme de Dicing Before Grinding) est très couramment utilisé. Il consiste à utiliser des puces déjà formées sur une plaque de silicium, qui sont prédécoupées à partir de la face avant de la plaque, puis amincies à partir de la face arrière, la face avant étant collée au préalable sur un film adhésif en matière plastique communément appelé 'tape' ou 'sticky'.

Ce procédé nécessite la mise en place d'une ligne complète pour l'amincissement de plaques présentant un diamètre minimum de 200 mm. Cette ligne comprend des enchaînements d'étapes, comme par exemple : l'étalement du film adhésif sur la face arrière de la plaque, une étape de découpe des puces, une étape de rectification (ou grinding) avec trois stades d'affinage : meulage grossier, meulage moyen et meulage très fin ou polissage à sec (connu sous le nom de dry polishing), une étape de retrait du stress par exemple par plasma ... et les outils et machines associées telle qu'une machine pour le dépôt du tape et pour le retrait du tape, un système de préhension des plaques de type Bernoulli (dans le cas de puces inférieures à 100 µm), un équipement de 'pick and place' pour la préhension et le montage des puces et leur mise en boitier, etc.

L'un des inconvénients rencontré avec une telle ligne est qu'elle est dédiée à un seul diamètre de plaque (par exemple 200 mm ou 300 mm). Par ailleurs, lorsqu'un cadre (ou frame) est utilisé, il est généralement en métal ce qui génère des risques de contamination des plaques et des puces de sorte qu'il est impossible d'effectuer des étapes complémentaires directement sur la ligne ou sur des appareils à la suite du procédé, tels que des polissages mécanique-chimique (CMP), nettoyage, gravure, collage, dépôts, implantation d'espèces ioniques... Dans les procédés classiques, la surface du frame métallique est ainsi volontairement maintenue très en dessous de la surface des zones à amincir (typiquement plusieurs centaines de micromètres, par exemple environ 700 µm). Dans le cas de contaminations, il est alors nécessaire de retirer les plaques contaminées ou les puces contaminées laminées sur un film adhésif pour une décontamination avant de pouvoir retrouver un environnement et des surfaces compatibles avec des traitements ultérieurs dans des équipements classiques de microélectronique.

Une autre méthode d'amincissement consiste à amincir des puces collectivement. Ces dernières sont collées sur un film adhésif, lui-même tendu et fixé sur un cadre métallique maintenu à un niveau inférieur à celui du plateau rotatif de meulage lors de l'amincissement, pour éviter toute mise en contact avec la meule. Toutefois, cette approche est limitée par deux inconvénients principaux : l'amincissement des plaques est restreint à l'obtention d'une épaisseur finale seuil d'environ 80 micromètres et l'attaque de la meule endommage nettement le bord des puces ou les flancs des substrats, de sorte que la défectuosité est trop importante. Ce dernier point est d'autant plus marqué que l'épaisseur de la puce est fine.

Les documents US-B-6 013 534 et US 2010/295 400 A1 décrivent de telles techniques de l'art antérieur.

Un des buts de la présente invention est de pallier au moins l'un de ces inconvénients. A cet effet, la présente invention propose un procédé d'amincissement d'échantillons pour des applications notamment dans le domaine de la micro-électronique, l'optoélectronique et les composants de puissance, le procédé comprenant les étapes de :
a) Fournir au moins un échantillon présentant une face avant, une face arrière opposée à la face avant et des flancs qui s'étendent entre la face avant et la face arrière,
b) Fournir un substrat d'encadrement présentant une première face et une seconde face opposée à la première face, le substrat d'encadrement comprenant une ouverture traversante débouchant dans la première face et dans la seconde face, l'ouverture traversante étant configurée pour recevoir l'au moins un échantillon,
c) Positionner l'au moins un échantillon par rapport au substrat d'encadrement de sorte que l'au moins un échantillon est disposé dans l'ouverture traversante, la face avant étant orientée du même côté que la première face, et
d) Amincir simultanément le substrat d'encadrement et l'au moins un échantillon à partir respectivement de la première face et de la face avant, de sorte qu'à la fin de l'amincissement, la première face du substrat d'encadrement et la face avant de l'au moins un échantillon s'étendent sensiblement dans le même plan, l'amincissement étant réalisé par rectification à l'aide d'une meule, le substrat d'encadrement et l'au moins un échantillon étant disposés sur un plateau rotatif et maintenus en place par aspiration, les flancs de l'au moins un échantillon restant libres pendant l'amincissement.

Ce procédé permet ainsi d'amincir en même temps l'échantillon et le substrat d'encadrement (ou frame) de sorte que l'attaque des outils d'amincissement est subie par le substrat d'encadrement. La défectuosité des bords de l'échantillon est ainsi amoindrie par comparaison avec un procédé de l'art antérieur. Cette méthode permet par ailleurs une grande polyvalence sur les caractéristiques des échantillons à amincir. Il est en effet possible d'adapter facilement la taille du substrat d'encadrement et celle de l'ouverture traversante à celle de l'échantillon ou aux besoins de traitements ultérieurs. L'amincissement d'un échantillon présentant un diamètre de 200 mm par exemple peut être suivi directement par un traitement dans des équipements standards dédiés à des plaques d'un diamètre 300 mm, grâce à l'utilisation d'un substrat d'encadrement dont le diamètre extérieur est de 300 mm. De plus, l'amincissement étant également réalisé sur le substrat d'encadrement, l'épaisseur initiale du substrat d'encadrement ne constitue plus une limite d'amincissement.

Cette méthode permet d'effectuer un amincissement régulier. De plus, l'amorce du meulage est faite principalement sur le substrat d'encadrement de sorte que l'écaillage de l'échantillon est limité. L'amincissement par polissage mécanique est éventuellement assisté par un polissage chimique.

Par ailleurs, les flancs des échantillons restant libres, les échantillons peuvent ensuite facilement être récupérés une fois amincis, notamment par des outils de « pick and place » classiques.

Selon une disposition de l'invention, le positionnement de l'au moins un échantillon par rapport à un échantillon adjacent ou par rapport au substrat d'encadrement ou par rapport à une paroi transversale partitionnant ledit substrat d'encadrement est réalisée selon une distance intercalaire D comprise entre 10 micromètres et 3000 micromètres.

De préférence, la distance intercalaire D est comprise entre 10 micromètres et 50 micromètres.

Selon une disposition, avant l'étape d'amincissement d), l'au moins un échantillon et le substrat d'encadrement sont configurés de sorte que la face avant de l'au moins un échantillon fait saillie de la première face du substrat d'encadrement d'une distance inférieure à 100 micromètres, de préférence inférieure à 50 micromètres et de préférence encore une distance inférieure à environ 30 micromètres, et l'étape d) comprend, avant l'amincissement simultané du substrat d'encadrement et de l'au moins un échantillon, une étape d1) d'amincissement de l'au moins un échantillon seul.

Avantageusement, avant l'étape d'amincissement d), l'au moins un échantillon et le substrat d'encadrement sont configurés de sorte que la face avant de l'au moins un échantillon est en retrait de la première face du substrat d'encadrement et l'étape d) comprend, avant l'amincissement simultané du substrat d'encadrement et de l'au moins un échantillon, une étape d1) d'amincissement du substrat d'encadrement seul, et de préférence, l'au moins un échantillon et le substrat d'encadrement sont configurés de sorte que la face avant de l'au moins un échantillon s'étend sensiblement dans le plan de la première face du substrat d'encadrement.

Ces dispositions permettent de limiter l'endommagement des bords des échantillons protégés des vibrations soumises par l'outil d'amincissement pouvant générer des écaillages. En cas de rectification, l'attaque de la meule est amorcée sur le substrat d'encadrement dès le démarrage lorsque le substrat d'encadrement présente une épaisseur similaire ou supérieure à celle de l'échantillon. Toutefois, en fin d'amincissement, quelles que soient les épaisseurs respectives initiales du substrat d'encadrement et de l'échantillon, la meule amorce la rectification sur le substrat d'encadrement de sorte que la défectuosité reste limitée par comparaison avec l'approche où la totalité de la rectification est effectuée directement sur l'échantillon sans protection. Il est à noter que la différence de niveaux de la face avant et de la première face est par exemple fixée par la précision de la spécification d'épaisseur de l'échantillon pour un échantillon de silicium cette précision est de l'ordre de 30 micromètres.

Lorsque le substrat d'encadrement fait saillie, celui-ci est aminci en premier. Lorsque l'échantillon forme saillie, celui-ci est aminci en premier.

Dans ce dernier cas, l'étape d1) comprend un amincissement par rectification effectué en plusieurs étapes, utilisant alors par exemple des meules à grains plus fins pour démarrer l'amincissement puis à grains plus gros pour l'amincissement simultané de l'échantillon et du substrat d'encadrement, (c'est à dire lorsque la face avant est dans le même plan que la première face) et ensuite éventuellement à grains plus fins pour terminer l'amincissement. Un démarrage de l'amincissement est envisageable par exemple avec des meules à grains fins (par ex de mesh 2000 ou 8000) puis poursuivant l'amincissement avec des meules à grains plus gros (par exemple des mesh 320). Cette approche est bien adaptée en particulier dans le cas de léger dépassement de la surface de l'échantillon à amincir par rapport à la première face du substrat d'encadrement.

Une alternative à la réalisation de l'étape d1) par rectification est un amincissement chimique, de préférence par voie sèche, jusqu'à ce que la face avant de l'au moins un échantillon s'étende environ dans le plan de la première face.

Selon une seconde alternative, l'amincissement de l'au moins un échantillon est suffisamment important pour retirer toute l'épaisseur de matériau de l'au moins un échantillon endommagé ou présentant de l'écaillage du fait de l'amincissement sur une portion en saillie.

Selon la rugosité de surface souhaitée, un polissage mécanique et chimique (CMP) peut être appliqué en face avant des échantillons après rectification.

Selon une disposition, le matériau du substrat d'encadrement est dépourvu de matériau susceptible de contaminer l'au moins un échantillon. L'étape consistant à amincir le substrat d'encadrement simultanément avec l'échantillon ne contamine donc pas ce dernier par des éléments indésirables. Par exemple on choisira un frame en silicium pour amincir des puces supportées par un substrat en silicium.

De préférence, le matériau de l'au moins un échantillon et le matériau du substrat d'encadrement sont choisis parmi le silicium, le verre, le saphir, l'oxyde d'aluminium, le carbure de silicium, le germanium, l'oxyde de niobium et de lithium (dit aussi niobate de lithium) LNO ou LiNbO3, l'oxyde de lithium et de titane (dit aussi tantalate de lithium) LTO, les éléments et les alliages d'éléments de la colonne IV, les éléments et les alliages d'éléments des colonnes III et V, les éléments et les alliages d'éléments des colonnes II et VI, et de préférence le matériau de l'au moins un échantillon et le matériau du substrat d'encadrement sont identiques.

L'amincissement du substrat d'encadrement et de l'au moins un échantillon est alors effectué à une vitesse similaire permettant d'atteindre une très bonne planéité. Par ailleurs, la poussière des particules générée par l'amincissement du substrat d'encadrement n'est pas contaminante de sorte que des traitements ultérieurs peuvent être appliqués à la suite, voire même en présence du frame.

Selon une possibilité, le matériau du substrat d'encadrement est choisi pour présenter la même vitesse d'amincissement que celle du matériau de l'au moins un échantillon.

De préférence, la taille de l'ouverture traversante mesurée dans le plan de la face avant est légèrement supérieure à la taille de l'échantillon mesurée dans le même plan de sorte à éviter tout frottement lors de la disposition de l'échantillon.

Selon une possibilité, l'étape c) comprend la disposition du substrat d'encadrement et de l'échantillon sur un support plan de sorte que la seconde face du substrat d'encadrement s'étend sensiblement dans le même plan que la face arrière de l'échantillon. Le procédé est ainsi facile à mettre en œuvre, il n'est pas nécessaire de maintenir la première face du substrat d'encadrement à une position très en dessous de celle de la face avant de l'échantillon comme ce serait le cas avec un substrat d'encadrement conventionnel en métal.

Selon une variante, le substrat d'encadrement présente une épaisseur supérieure à celle de l'au moins un échantillon de sorte qu'après l'étape d'amincissement d) le substrat d'encadrement présente une épaisseur supérieure à 150 micromètres. Cette épaisseur lui permet de conserver des propriétés mécaniques suffisantes pour être manipulé, avec l'échantillon aminci en même temps dans le substrat d'encadrement. Il est alors aisé de réaliser de nouvelles étapes sur l'échantillon aminci et maintenu dans le substrat d'encadrement resté rigide. L'amincissement possible de l'échantillon est d'autant plus important et l'amincissement peut aller jusqu'à obtenir un échantillon dont l'épaisseur est bien inférieure à 40 micromètres. L'épaisseur de l'échantillon peut être amincie à 30 micromètres par exemple.

Selon une possibilité, la seconde face du substrat d'encadrement fait saillie de la face arrière de l'échantillon. Cette configuration, malgré une épaisseur plus importante du substrat d'encadrement, permet à ce dernier de conserver une première face sensiblement dans le même plan que celui de la face avant de l'échantillon. Dans ce cas, la seconde face du substrat d'encadrement est maintenue en saillie de la face arrière de l'échantillon pour que la face avant et la première face soient amincies simultanément.

De préférence, l'au moins un échantillon fourni à l'étape a) comprend un substrat ou un composant, par exemple pour une application électronique, telle qu'une puce. Par l'expression 'composant', on entend dans le présent document aussi bien un composant complexe tel qu'un CMOS, une mémoire, un composant optique, optronique, un capteur, un MEMS, un composant réalisé par une ou des techniques développées en micro et nanotechnologies, biotechnologies etc.... qu'un composant simple telle qu'une interconnexion électrique. L'échantillon peut être constitué d'un seul matériau ou de plusieurs matériaux, vierge ou déjà soumis à diverses étapes technologiques avant son amincissement.

Les traitements ultérieurs rendus directement accessibles par le procédé de l'invention, selon l'étape e) sont notamment des étapes de gravure par voie sèche ou par voie humide, de dépôt, de planarisation, de polissage, de nettoyage, d'encapsulation de puces dans des boitiers électroniques, de collage direct de puces pour un report, etc.

Avantageusement, le procédé comprend entre l'étape c) et l'étape d) une étape c1) de mise en place, par exemple par laminage, d'un premier film adhésif sur le substrat d'encadrement et sur l'au moins un échantillon par adhésion du premier film adhésif respectivement sur la seconde face et la face arrière. Ceci facilite la manipulation de l'échantillon notamment si celui-ci présente une épaisseur très fine après amincissement. Par ailleurs, la présence de ce premier film adhésif permet d'absorber les éventuelles petites différences de niveaux entre la face avant et la première face.

Dans le cas où le substrat d'encadrement présente une épaisseur beaucoup plus importante que celle de l'échantillon, une étape d'emboitement du premier film adhésif et du substrat d'encadrement permet d'élever l'échantillon et de placer la face avant et la première face du substrat d'encadrement sur un plan sensiblement similaire pour un amincissement simultané.

Selon une possibilité, l'étape c1) est suivie d'une étape c2) comprenant la découpe du film adhésif suivant le pourtour périphérique du substrat d'encadrement.

Selon une possibilité, l'étape c) comprend la disposition du substrat d'encadrement sur le plateau rotatif suivi de la disposition de l'au moins un échantillon dans l'ouverture traversante du substrat d'encadrement. Cette variante est notamment avantageuse lorsque l'épaisseur finale de l'échantillon aminci permet d'éviter l'utilisation du premier film adhésif, cette épaisseur est par exemple de 150 micromètres environ pour un échantillon de silicium. Elle permet alors de protéger les flancs de l'échantillon lors de l'amorce de l'amincissement par la meule et aussi d'obtenir une faible variation d'épaisseur totale (connue également sous l'acronyme TTV pour Total Thickness Variation).

Selon une variante de réalisation, l'étape c) comprend le positionnement de l'au moins un échantillon sur un support plan puis la disposition du substrat d'encadrement sur ledit support plan de sorte que l'ouverture traversante entoure l'au moins un échantillon.

Selon une variante de réalisation, l'étape a) comprend la fourniture d'une pluralité d'échantillons, et
l'étape b) comprend la fourniture d'un substrat d'encadrement comprenant une ouverture traversante unique dans laquelle la pluralité d'échantillons est disposée à l'étape c), ou
l'étape b) comprend la fourniture d'un substrat d'encadrement comprenant un ensemble d'ouvertures traversantes et l'étape c) comprend la disposition de chaque échantillon dans une ouverture traversante respective.

Cette configuration permet l'amincissement simultané de plusieurs échantillons pouvant présenter chacun des tailles différentes. Le substrat d'encadrement est également adaptable en proposant un ensemble d'ouvertures traversantes bordées par des zones non ouvertes, notamment utiles dans le cas où les échantillons sont fragiles et de très petites tailles. Les bords des échantillons sont en effet mieux protégés de l'amorce de l'amincissement par la meule du fait de la proximité de zones non ouvertes et le premier film adhésif est également très bien protégé par la présence de ces zones non ouvertes de sorte que d'autres traitements ultérieurs peuvent être appliqués directement. Par exemple, dans le cas d'un polissage par CMP, le plan supérieur des échantillons n'est que très peu arrondi du fait que les bords des échantillons sont très proches. Par ailleurs, lors de gravures humides ou sèches, très peu de zones du premier film adhésif sont exposées à la gravure de sorte que la dégradation dudit premier film est très faible.

Selon une possibilité, l'étape a) comprend la fourniture d'une pluralité d'échantillons et l'étape c) comprend une gestion individualisée de la disposition de chaque échantillon. Chacun des échantillons est alors prélevé et disposé individuellement par exemple par une précelle ou à l'aide d'un outil automatisé. Un système de « pick and place » permet par exemple une grande rapidité d'exécution de ces étapes.

Selon une alternative, l'étape a) comprend la fourniture d'une pluralité d'échantillons et l'étape c) comprend la disposition collective de la pluralité d'échantillons. Selon une autre variante de réalisation, l'étape a) comprend les étapes de :
i) Fournir une plaque comprenant une pluralité d'échantillons,
ii) Mettre en place un deuxième film adhésif sur la plaque par laminage,
iii) Découper la plaque de sorte à individualiser les échantillons solidarisés au deuxième film adhésif, et
l'étape c) comprend les étapes de :
iv) Reporter le deuxième film adhésif sur le substrat d'encadrement de sorte à disposer collectivement la pluralité d'échantillons, et
v) Retirer le deuxième film adhésif.

Ainsi, la disposition de la pluralité des échantillons est collective, rapide et effectuée de façon précise.

De préférence, l'ouverture traversante dans le substrat d'encadrement fourni à l'étape b) est réalisée par une étape b1) de percement du substrat d'encadrement à partir de la première face ou de la seconde face de sorte à obtenir une ouverture traversante débouchant dans la première face et dans la seconde face. Le substrat d'encadrement est préparé (par exemple planarisé) au préalable lorsque cela est nécessaire de sorte à présenter un état de surface compatible avec des traitements ultérieurs à l'amincissement auxquels il peut être soumis en même temps que les échantillons.

Selon une possibilité, l'étape de percement b1) comprend une étape de rectification mécanique (autrement dit 'amincissement') suivie d'une étape de gravure chimique.

Selon une autre variante, l'étape de percement b1) comprend une étape de rectification mécanique à partir de la première face du substrat d'encadrement de sorte à créer un évidement, et une étape d'amincissement localisé, réalisée sur la seconde face jusqu'à atteindre l'évidement de sorte à obtenir l'ouverture traversante.

Selon encore une autre variante, l'étape de percement b1) comprend une gravure sèche ou une gravure humide.

Selon une disposition, l'étape de percement b1) comprend plusieurs percements réalisés par laser, par découpe mécanique, par ultrasons ou par gravure en voie sèche ou en voie humide, de sorte à obtenir un ensemble d'ouvertures traversantes.

D'autres aspects, buts et avantages de la présente invention apparaîtront mieux à la lecture de la description suivante de différents modes de réalisation de celle-ci, donnés à titre d'exemples non limitatifs et faits en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques.
- Les figures 1 à 7 représentent schématiquement un premier mode de réalisation du procédé selon l'invention.
- Les figures 8 à 10 illustrent chacune une variante du premier mode de réalisation selon l'invention.
- Les figures 11 à 14 représentent schématiquement un deuxième mode de réalisation du procédé selon l'invention.
- La figure 15 illustre schématiquement une variante du deuxième mode de réalisation du procédé selon l'invention.

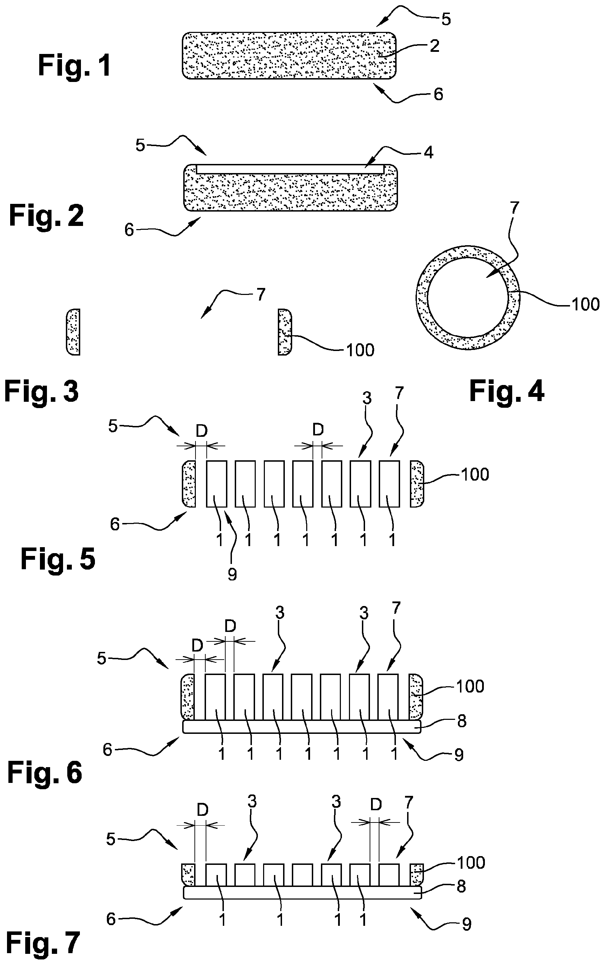

Les figures 1 à 4 illustrent un procédé de préparation d'un substrat d'encadrement 100 pour l'amincissement d'un échantillon 1. Un substrat d'encadrement 100 est tout d'abord fourni sous la forme d'une tranche 2 d'une épaisseur d'environ 725 micromètres provenant par exemple de la découpe d'un lingot en silicium (figure 1). Une étape de rectification mécanique est réalisée à partir de la première face 5 de sorte à créer un évidement 4 central dans la tranche 2, présentant une profondeur d'environ 50 micromètres (figure 2). Le diamètre de la tranche 2 est d'environ 200 mm et l'évidement 4 présente un diamètre de 180 mm de sorte à préformer un anneau d'une largeur d'environ 10 mm, définie entre le rayon extérieur et le rayon intérieur de l'anneau. Puis, la tranche 2 est retournée pour présenter la seconde face 6 opposée à la première face 5. Un amincissement est alors réalisé à partir de la seconde face 6 de sorte à ouvrir l'évidement 4 précédemment formé (figure 3). Un substrat d'encadrement 100 de silicium présentant une ouverture traversante 7 débouchant dans la première face 5 et dans la seconde face 6 est alors obtenu. Selon une variante non illustrée, après la découpe dans le lingot et avant la réalisation d'un évidement 4, la tranche 2 est soumise à des traitements complémentaires d'amincissement, de gravure et/ou de préparations de surfaces, bien connus en microélectronique ou microtechnologie. Ces traitements ont pour effet de diminuer la rugosité des surfaces brutes de découpe ou d'enlever les dommages et stress engendrés par la découpe du lingot.

La figure 4 illustre une vue du dessus du substrat d'encadrement 100 présentant globalement la forme d'un anneau. D'autres techniques de formation de l'ouverture traversante 7 non illustrées sont envisageables. Selon une possibilité, un procédé d'amincissement par meule (rectification) est appliqué : la première étape de rectification est suivie d'une gravure chimique pour ouvrir l'évidement 4 dans la seconde face 6. Selon encore d'autres possibilités, l'ouverture traversante 7 est réalisée, par exemple, par gravure humide ou par gravure sèche, par découpe mécanique ou laser, usinage par ultrasons ou par une combinaison quelconque de ces techniques.

Selon une disposition, le substrat d'encadrement 100 est réalisé à partir d'un matériau différent du silicium tel que le verre, le saphir, l'oxyde d'aluminium, le carbure de silicium, le germanium, l'oxyde de niobium et de lithium LiNbO₃ (LNO), l'oxyde de lithium et de titane LTO, les éléments et les alliages d'éléments de la colonne IV, les éléments et les alliages d'éléments des colonnes III et V, tel que l'InP, AsGa, et les éléments et les alliages d'éléments des colonnes II et VI, tel que le CZT alliage de tellurure de cadmium et de zinc, ou d'autres matériaux non contaminants, présentant des propriétés mécaniques proches de celles des échantillons à amincir permettant ainsi une vitesse d'amincissement similaire, et compatibles avec les techniques utilisées en micro-électroniques et avec la nature des échantillons 1 à amincir. Les substrats d'encadrement 100 en métal sont en général proscrits.

Selon une autre variante, le substrat d'encadrement 100 est formé à partir d'une plaquette d'un matériau précédemment cité notamment quand le matériau n'est pas disponible sous la forme d'une tranche 2 provenant d'un lingot.

Les figures 5 à 7 illustrent l'amincissement d'une pluralité d'échantillons 1 disposés dans l'ouverture traversante 7 du substrat d'encadrement 100. La pluralité d'échantillons 1 est composée par une pluralité de composants électroniques. Selon une autre possibilité, les échantillons 1 peuvent être formés de substrats à amincir, notamment constitués dans les matériaux précités concernant le substrat d'encadrement. Ces échantillons 1 sont prélevés et disposés de façon individuelle dans l'ouverture traversante 7 par un outil automatisé permettant la gestion individuelle de chacun des échantillons 1. Puis, un premier film adhésif 8 est mis en place par laminage sur la seconde face 6 du substrat d'encadrement 100 et sur une face arrière 9 des échantillons 1 de sorte que lesdites faces 6,9 s'étendent dans un même plan (étape c1- figure 6). Le premier film adhésif 8 comprend un film en matière plastique extensible, recouvert d'un adhésif sensible à l'insolation aux UV de sorte à faciliter le retrait du film. Il est ensuite découpé avec un laminateur manuel de type Powatec ou un laminateur automatisé autour de la périphérie du substrat d'encadrement 100.

Comme illustré aux figures 5 et 6, les épaisseurs des échantillons 1 et du substrat d'encadrement 100 sont similaires. Ainsi, les faces exposées, à savoir la face avant 3 des échantillons 1 et la première face 5 du substrat d'encadrement 100 s'étendent sensiblement dans le même plan. Cet ensemble formé de la pluralité des échantillons 1 et du substrat d'encadrement 100 est alors disposé, grâce au premier film adhésif 8 qui réunit l'ensemble, sur un plateau rotatif permettant de maintenir l'ensemble en place par aspiration (non illustré). Une rectification est alors entamée à l'aide d'une meule diamantée de sorte à amincir simultanément le substrat d'encadrement 100 et les échantillons 1. L'amorce de la meule ayant lieu sur le substrat d'encadrement 100, les flancs des échantillons 1 sont protégés. La variation de l'épaisseur totale des échantillons 1 en est également améliorée. De même, la dispersion des valeurs d'épaisseurs des divers échantillons est également améliorée.

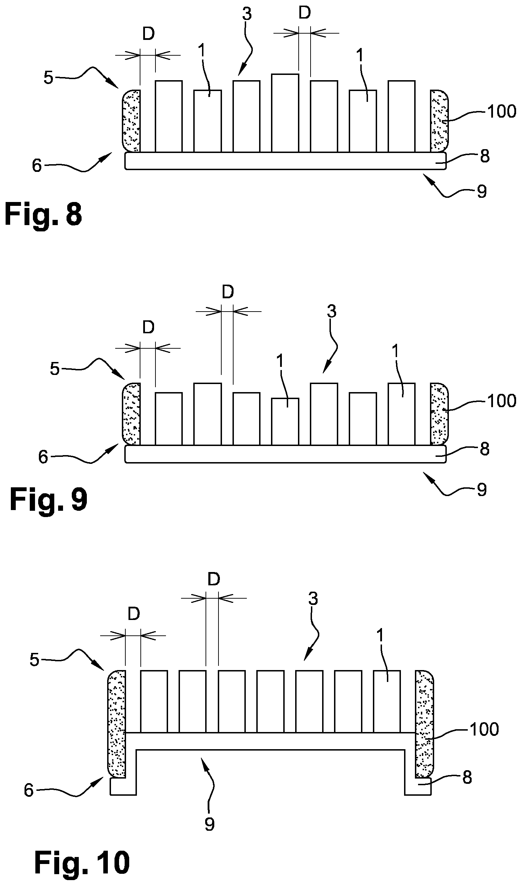

Selon une autre disposition représentée aux figures 8 et 9, la face avant 3 des échantillons 1 n'est pas parfaitement alignée avec la première face 5 du substrat d'encadrement 100. A la figure 8, la pluralité d'échantillons 1 présente une épaisseur plus importante que celle du substrat d'encadrement 100 ou tout du moins leur face avant 3 dépasse la première face 5 du substrat d'encadrement 100 de tout au plus 100 µm, ou mieux 50 µm ou mieux encore de 30 µm de sorte à limiter l'apparition de défectuosités sur les flancs des échantillons 1. Avantageusement, la première face 5 du substrat d'encadrement 100 dépasse de la face avant 3 des échantillons 1 ou s'étend sensiblement dans le même plan afin de réduire au maximum la formation de défauts sur les flancs des échantillons 1 au cours de la rectification (figure 9).

Le substrat d'encadrement 100 constitué en un matériau non polluant peut être aminci par rectification jusqu'à ce que l'épaisseur souhaitée des échantillons 1 soit atteinte. Ainsi, la limite classique d'un amincissement à 80 micromètres selon la technique DBG peut être ici diminuée à 40 micromètres, sans pour autant contaminer les composants électroniques 1.

Comme illustré à la figure 10, il est possible de diminuer encore l'épaisseur finale des échantillons 1 grâce à un substrat d'encadrement 100 présentant une épaisseur nettement plus importante que celle des échantillons 1 à amincir, de sorte à conserver sa rigidité et sa capacité à être manipulé après l'étape d'amincissement. Par exemple, lorsque le substrat d'encadrement 100 fourni à l'étape a) présente une épaisseur de 1200 micromètres, l'étape d) d'amincissement effectuée sur une épaisseur de 650 micromètres conduit à l'obtention d'un substrat d'encadrement 100 présentant une épaisseur de 550 micromètres, lui garantissant une tenue mécanique suffisante pour assurer le déplacement ou la manipulation de puces 1 pour l'étape e) d'au moins un traitement ultérieur.

Egalement, comme illustré à la figure 10, la première face 5 du substrat d'encadrement 100 est sensiblement alignée sur la face avant 3 des échantillons 1 de sorte que l'étape d) d'amincissement est immédiatement réalisée de façon simultanée sur les échantillons 1 et le substrat d'encadrement 100. Ceci est obtenu en abaissant le niveau de la seconde face 6 du substrat d'encadrement 100 qui fait ainsi saillie de la face arrière 4 des échantillons, par exemple par emboitement via le cylindre d'aspiration 9 (ou 'chuck'), en présence du premier film adhésif 8.

Selon une variante non illustrée, l'emboitement est réalisé en absence du premier film adhésif 8.

Selon une variante non illustrée, la pluralité d'échantillons 1 est disposée de façon collective dans le substrat d'encadrement 100 en utilisant un deuxième film adhésif 11. Cette variante comprend la fourniture d'une plaque comprenant une pluralité d'échantillons 1 tels que des puces électroniques (étape i). Le deuxième film adhésif 11 est disposé sur la face exposée de la pluralité de puces, à savoir la face avant 3 destinée à être amincie (étape ii). La plaque est ensuite découpée de sorte à individualiser chacune des puces 1 qui restent adhérentes au deuxième film adhésif 11 (étape iii). Puis selon l'étape c) du procédé, le deuxième film adhésif 11 est reporté sur le substrat d'encadrement 100 de sorte à disposer de façon collective la pluralité de puces 1 dans l'ouverture traversante 7. Le deuxième film adhésif 11 est ensuite retiré (étape iv) et v) libérant les faces avant 3 de chacune des puces 1.

Selon une autre possibilité non illustrée, chacun des échantillons 1 de la pluralité d'échantillons 1 est disposé à l'aide d'un système de « pick and place » dans l'ouverture traversante 7.

On peut noter que dans la forme de réalisation du procédé selon l'invention montrée aux figures 1 à 7, dans la variante de réalisation montrée aux figures 8 à 10, ainsi que dans les variantes de réalisation décrites précédemment, les échantillons 1 sont disposés sur le substrat d'encadrement 100 avec une distance intercalaire D (i) entre les flancs d'échantillons 1 adjacents et (ii) entre les flancs d'échantillon 1 de rive avec le substrat d'encadrement 100 qui est supérieur à 10 micromètres et typiquement comprise entre 10 et 50 micromètres. En d'autres termes, les échantillons 1 présentent entre eux et avec le substrat d'encadrement 100 une liberté latérale ce qui autorise leur préhension par un système de « pick and place ». La distance intercalaire D libre mais doit rester préférentiellement inférieure à 3 mm pour éviter un effet de bord lors de l'étape d'amincissement qui pourrait arrondir la face avant 3 des échantillons 1.

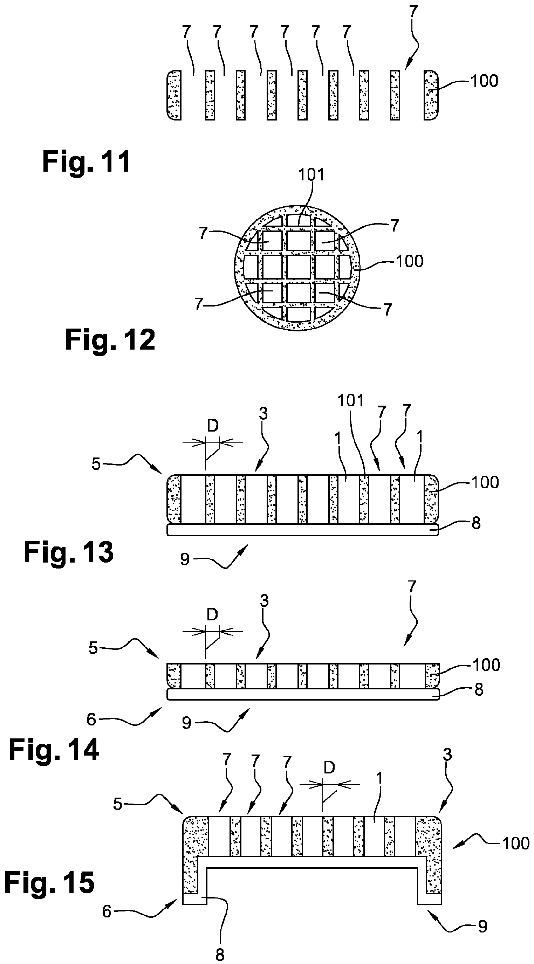

Les figures 11 à 14 illustrent un deuxième mode de réalisation qui diffère du précédent en ce qu'une pluralité d'échantillons 1 est disposée dans un substrat d'encadrement 100 présentant un ensemble d'ouvertures traversantes 7. Cet ensemble d'ouvertures traversantes 7 est obtenu par découpe laser à la taille des échantillons 1, et conduit à la formation d'un substrat d'encadrement 100 présentant globalement une forme de pochoir, illustré selon une vue en section à la figure 11 et une vue de dessus à la figure 12. Une découpe mécanique ou par ultrasons, gravure en voie sèche, gravure en voie humide etc., à travers le substrat d'encadrement 100 est également possible pour générer cet ensemble d'ouvertures traversantes 7 délimitées par un réseau de parois transversales 101 qui dans le mode de réalisation illustré sont perpendiculaires. Dans ce mode de réalisation, chaque échantillon 1 est disposé dans une ouverture traversante 7 respective aux dimensions légèrement plus importantes que celles de l'échantillon 1 de sorte à éviter tout frottement lors de la disposition de l'échantillon 1 (figure 13- la différence de dimensions n'y est pas visible). Le bord des échantillons 1 est ainsi encore plus protégé de l'attaque de la meule et le premier film adhésif 8 laminé sur la face arrière 9 des échantillons 1 et de la seconde face 6 du substrat d'encadrement 100 est davantage masqué ce qui permet une large palette de traitements ultérieurs, notamment appliqués sur la face avant 3 des échantillons 1 (figure 14).

La figure 15 illustre une variante de réalisation appliquée au substrat d'encadrement 100 comportant une pluralité d'ouvertures traversantes 7, déjà discutée en relation avec la figure 10. En effet, le substrat d'encadrement 100 présente une épaisseur nettement plus importante que celle des échantillons 1 à amincir et la deuxième face 6 du substrat d'encadrement 100 fait saillie de la face arrière 4 des échantillons 1. Ceci permet avantageusement la réalisation d'un amincissement simultané selon l'étape d) et de conserver une tenue mécanique importante du substrat d'encadrement 100 même en fin d'amincissement.

Selon une possibilité non illustrée, la présente invention propose également un amincissement d'un seul échantillon 1 disposé dans une ouverture traversante 7 dédiée dans un substrat d'encadrement 100.

On peut noter que dans la forme de réalisation du procédé selon l'invention montrée aux figures 11 à 15, ainsi que dans les variantes de réalisation décrites précédemment, les échantillons 1 sont disposés sur le substrat d'encadrement 100 avec une distance intercalaire D entre les flancs d'échantillons 1 adjacents et le paroi transversale du substrat d'encadrement qui est typiquement comprise entre 10 micromètres et 50 micromètres. En d'autres termes, les échantillons 1 présentent avec les parois 101 du substrat d'encadrement 100 une liberté latérale ce qui autorise leur préhension par un système de « pick and place ». Cette distance intercalaire D est libre mais est préférentiellement inférieure à 3000 micromètres afin d'éviter un effet de bord lors de l'étape d'amincissement qui pourrait arrondir la face avant 3 des échantillons 1.

Ainsi, la présente invention propose un procédé d'amincissement d'échantillons 1 pouvant prendre la forme de substrat ou de composants électroniques tels que des puces, des composants optiques, optroniques, des capteurs, des MEMS, etc.... avec une très bonne planéité, en limitant la défectuosité des bords, en évitant la contamination, en permettant d'atteindre des épaisseurs très fines. Ceci permet par exemple d'obtenir des surfaces adaptées au collage par adhésion moléculaire pour un report de puces comprenant ou non une étape d'implantation d'espèces ioniques pour des applications photoniques. D'autres traitements ultérieurs peuvent être directement appliqués sur les échantillons 1 amincis, tels que l'élaboration de puces fines pour une encapsulation dans des boitiers électroniques, des couches fines d'alliage de matériaux III/V pour des applications en optoélectronique (fabrication de LED) ou de couches fines de LTO /LNO pour fabriquer des filtres RF.

## Revendications

1. Procédé d'amincissement d'échantillons (1) pour des applications notamment dans le domaine de la micro-électronique, l'optoélectronique et les composants de puissance, le procédé comprenant les étapes de :
a) Fournir au moins un échantillon (1) présentant une face avant (3), une face arrière (9) opposée à la face avant (3) et des flancs qui s'étendent entre la face avant (3) et la face arrière (9),
b) Fournir un substrat d'encadrement (100) présentant une première face (5) et une seconde face (6) opposée à la première face (5), le substrat d'encadrement (100) comprenant une ouverture traversante (7) débouchant dans la première face (5) et dans la seconde face (6), l'ouverture traversante (7) étant configurée pour recevoir l'au moins un échantillon (1),
c) Positionner l'au moins un échantillon (1) par rapport au substrat d'encadrement (100) de sorte que l'au moins un échantillon (1) est disposé dans l'ouverture traversante (7), la face avant (3) étant orientée du même coté que la première face (5), et
d) Amincir simultanément le substrat d'encadrement (100) et l'au moins un échantillon (1) à partir respectivement de la première face (5) et de la face avant (3), de sorte qu'à la fin de l'amincissement, la première face (5) du substrat d'encadrement (100) et la face avant (3) de l'au moins un échantillon (1) s'étendent sensiblement dans le même plan, l'amincissement étant réalisé par rectification à l'aide d'une meule, le substrat d'encadrement (100) et l'au moins un échantillon (1) étant disposés sur un plateau rotatif et maintenus en place par aspiration, les flancs de l'au moins un échantillon restant libres pendant l'amincissement.

2. Procédé d'amincissement selon la revendication 1, **caractérisé en ce que** le positionnement de l'au moins un échantillon (1) par rapport à un échantillon (1) adjacent ou par rapport au substrat d'encadrement (100) ou par rapport à une paroi transversale (101) partitionnant ledit substrat d'encadrement est réalisée selon une distance intercalaire (D) comprise entre 10 micromètres et 3000 micromètres.

3. Procédé d'amincissement selon la revendication 2, **caractérisé en ce que** la distance intercalaire (D) est comprise entre 10 micromètres et 50 micromètres.

4. Procédé d'amincissement selon l'une des revendications 1 à 3, dans lequel, avant l'étape d'amincissement d), l'au moins un échantillon (1) et le substrat d'encadrement (100) sont configurés de sorte que la face avant (3) de l'au moins un échantillon (1) fait saillie de la première face (5) du substrat d'encadrement (100) d'une distance inférieure à 100 micromètres, de préférence inférieure à 50 micromètres et de préférence encore une distance inférieure à environ 30 micromètres, et l'étape d) comprend, avant l'amincissement simultané du substrat d'encadrement (100) et de l'au moins un échantillon (1), une étape d1) d'amincissement de l'au moins un échantillon (1) seul.

5. Procédé d'amincissement selon l'une des revendications 1 à 4, dans lequel, avant l'étape d'amincissement d), l'au moins un échantillon (1) et le substrat d'encadrement (100) sont configurés de sorte que la face avant (3) de l'au moins un échantillon (1) est en retrait de la première face (5) du substrat d'encadrement (100) et dans lequel l'étape d) comprend, avant l'amincissement simultané du substrat d'encadrement (100) et de l'au moins un échantillon (1), une étape d1) d'amincissement du substrat d'encadrement (100) seul, et de préférence, l'au moins un échantillon (1) et le substrat d'encadrement (100) sont configurés de sorte que la face avant (3) de l'au moins un échantillon (1) s'étend sensiblement dans le plan de la première face (5) du substrat d'encadrement (100).

6. Procédé d'amincissement selon l'une des revendications 1 à 5, comprenant après l'étape d) au moins une étape de traitement e) de l'au moins un échantillon (1) disposé dans l'ouverture traversante (7) du substrat d'encadrement (100), telle qu'une étape de gravure par voie sèche ou par voie humide, de dépôt, de planarisation, de polissage, de nettoyage, d'encapsulation dans des boitiers électroniques ou de collage direct.

7. Procédé d'amincissement selon l'une des revendications 1 à 6, dans lequel le matériau de l'au moins un échantillon (1) et le matériau du substrat d'encadrement (100) sont choisis parmi le silicium, le verre, le saphir, l'oxyde d'aluminium, le carbure de silicium, le germanium, l'oxyde de niobium et de lithium LNO, l'oxyde de lithium et de titane LTO, les éléments et alliages d'éléments des colonnes IV, les éléments et les alliages d'éléments des colonnes III et V, et les éléments et les alliages d'éléments des colonnes II et VI, et de préférence le matériau de l'au moins un échantillon (1) et le matériau du substrat d'encadrement (100) sont identiques.

8. Procédé d'amincissement selon l'une des revendications 1 à 7, comprenant entre l'étape c) et l'étape d) une étape c1) de mise en place, notamment par laminage, d'un premier film adhésif (8) sur le substrat d'encadrement (100) et sur l'au moins un échantillon (1) par adhésion du premier film adhésif (8) respectivement sur la seconde face (6) et sur la face arrière (9).

9. Procédé d'amincissement selon l'une des revendications 1 à 8, dans lequel le substrat d'encadrement (100) présente une épaisseur supérieure à celle de l'au moins un échantillon (1) de sorte qu'après l'étape d'amincissement d) le substrat d'encadrement (100) présente une épaisseur supérieure à 150 micromètres.

10. Procédé d'amincissement selon l'une des revendications 1 à 9, dans lequel la seconde face (6) du substrat d'encadrement (100) fait saillie de la face arrière (9) de l'au moins un échantillon (1).

11. Procédé d'amincissement selon l'une des revendications 1 à 10, dans lequel l'étape a) comprend la fourniture d'une pluralité d'échantillons (1), et
dans lequel l'étape b) comprend la fourniture d'un substrat d'encadrement (100) comprenant une ouverture traversante (7) unique dans laquelle la pluralité d'échantillons (1) est disposée à l'étape c), ou
dans lequel l'étape b) comprend la fourniture d'un substrat d'encadrement (100) comprenant un ensemble d'ouvertures traversantes (7) et l'étape c) comprend la disposition de chaque échantillon (1) dans une ouverture traversante (7) respective.

12. Procédé d'amincissement selon l'une des revendications 1 à 11, dans lequel l'étape a) comprend la fourniture d'une pluralité d'échantillons (1) et dans lequel l'étape c) comprend la disposition individuelle de chaque échantillon (1).

13. Procédé d'amincissement selon l'une des revendications 1 à 11, dans lequel l'étape a) comprend la fourniture d'une pluralité d'échantillons (1) et dans lequel l'étape c) comprend la disposition collective de la pluralité d'échantillons (1).

14. Procédé d'amincissement selon la revendication 13, dans lequel l'étape a) comprend les étapes de :
i) Fournir une plaque comprenant une pluralité d'échantillons (1),
ii) Mettre en place par laminage un deuxième film adhésif (11) sur la plaque,
iii) Découper la plaque de sorte à individualiser les échantillons (1) solidarisés au deuxième film adhésif (11), et
dans lequel l'étape c) comprend les étapes de :
iv) Reporter le deuxième film adhésif (11) sur le substrat d'encadrement (100) de sorte à disposer collectivement la pluralité d'échantillons (1), et
v) Retirer le deuxième film adhésif (11).

## Patentansprüche

1. Verfahren zur Verdünnung von Proben (1) für Anwendungen insbesondere auf dem Gebiet der Mikroelektronik, Optoelektronik und Leistungsbauelementen, wobei das Verfahren die folgenden Schritte umfasst:
a) Bereitstellen wenigstens einer Probe (1), aufweisend eine vordere Fläche (3), eine der vorderen Fläche (3) gegenüberliegende hintere Fläche (9) und Flanken, die sich zwischen der vorderen Fläche (3) und der hinteren Fläche (9) erstrecken,
b) Bereitstellen eines Einfassungs-Substrats (100), aufweisend eine erste Fläche (5) und eine der ersten Fläche (5) gegenüberliegende zweite Fläche (6), wobei das Einfassungs-Substrat (100) eine durchgehende Öffnung (7) umfasst, in die erste Fläche (5) und in die zweite Fläche (6) mündend, wobei die durchgehende Öffnung (7) konfiguriert ist, um wenigstens eine Probe (1) aufzunehmen,
c) Positionieren der wenigstens einen Probe (1) in Bezug auf das Einfassungs-Substrat (100), sodass die wenigstens eine Probe (1) in der durchgehenden Öffnung (7) angeordnet ist, wobei die vordere Fläche (3) zur gleichen Seite hin ausgerichtet ist wie die erste Fläche (5), und
d) simultanes Verdünnen des Einfassungs-Substrats (100) und der wenigstens einen Probe (1) ausgehend jeweils von der ersten Fläche (5) und der vorderen Fläche (3), sodass sich am Ende der Verdünnung die erste Fläche (5) des Einfassungs-Substrats (100) und die vordere Fläche (3) der wenigstens einen Probe (1) im Wesentlichen in der gleichen Ebene erstrecken, wobei die Verdünnung durchgeführt wird durch Berichtigung mithilfe eines Schleifkörpers, wobei das Einfassungs-Substrat (100) und die wenigstens eine Probe (1) auf einem Drehteller angeordnet sind und durch Ansaugung an Ort und Stelle gehalten werden, wobei die Flanken der wenigstens einen Probe während der Verdünnung frei bleiben.

2. Verfahren zur Verdünnung nach Anspruch 1, **dadurch gekennzeichnet, dass** die Positionierung der wenigstens einen Probe (1) in Bezug auf eine angrenzende Probe (1) oder in Bezug auf das Einfassungs-Substrat (100) oder in Bezug auf eine querverlaufende, das Einfassungs-Substrat teilende Wand (101) gemäß einem dazwischenliegenden Abstand (D) durchgeführt wird, zwischen 10 Mikrometern und 3 000 Mikrometern betragend.

3. Verfahren zur Verdünnung nach Anspruch 2, **dadurch gekennzeichnet, dass** der dazwischenliegende Abstand (D) zwischen 10 Mikrometern und 50 Mikrometern beträgt.

4. Verfahren zur Verdünnung nach einem der Ansprüche 1 bis 3, in welchem vor dem Schritt des Verdünnens d) wenigstens eine Probe (1) und das Einfassungs-Substrat (100) so konfiguriert sind, dass die vordere Fläche (3) der wenigstens einen Probe (1) von der ersten Fläche (5) des Einfassungs-Substrats (100) hervorsteht mit einem Abstand kleiner als 100 Mikrometer, bevorzugt kleiner als 50 Mikrometer und bevorzugter einem Abstand kleiner als ungefähr 30 Mikrometer, und der Schritt d) vor der simultanen Verdünnung des Einfassungs-Substrats (100) und der wenigstens einen Probe (1) einen Schritt d1) des Verdünnens der wenigstens einen Probe (1) allein umfasst.

5. Verfahren zur Verdünnung nach einem der Ansprüche 1 bis 4, in welchem vor dem Schritt des Verdünnens d) die wenigstens eine Probe (1) und das Einfassungs-Substrat (100) so konfiguriert sind, dass die vordere Fläche (3) der wenigstens einen Probe (1) von der ersten Fläche (5) des Einfassungs-Substrats (100) zurückgesetzt ist und in welchem der Schritt d) vor der simultanen Verdünnung des Einfassungs-Substrats (100) und der wenigstens einen Probe (1) einen Schritt d1) des Verdünnens des Einfassungs-Substrats (100) allein umfasst, und bevorzugt die wenigstens eine Probe (1) und das Einfassungs-Substrat (100) so konfiguriert sind, dass sich die vordere Fläche (3) der wenigstens einen Probe (1) im Wesentlichen in der Ebene der ersten Fläche (5) des Einfassungs-Substrats (100) erstreckt.

6. Verfahren zur Verdünnung nach einem der Ansprüche 1 bis 5, umfassend nach Schritt d) wenigstens einen Schritt der Behandlung e) der wenigstens einen in der durchgehenden Öffnung (7) des Einfassungs-Substrats (100) angeordneten Probe (1), beispielsweise einen Schritt der Gravur auf trockenem oder auf feuchtem Wege, der Abscheidung, der Planarisierung, der Politur, der Reinigung, der Verkapselung in elektronische Gehäuse oder des direkten Aufklebens.

7. Verfahren zur Verdünnung nach einem der Ansprüche 1 bis 6, in welchem das Material der wenigstens einen Probe (1) und das Material des Einfassungs-Substrats (100) ausgewählt sind aus Silizium, Glas, Saphir, Aluminiumoxid, Siliziumkarbid, Germanium, Niob- und Lithiumoxid LNO, Lithium- und Titanoxid LTO, Elementen und Legierungen von Elementen der IV. Hauptgruppe, Elementen und Legierungen von Elementen der III. und V. Hauptgruppen, und Elementen und Legierungen von Elementen der II. und VI. Hauptgruppen, und bevorzugt das Material der wenigstens einen Probe (1) und das Material des Einfassungs-Substrats (100) identisch sind.

8. Verfahren zur Verdünnung nach einem der Ansprüche 1 bis 7, umfassend zwischen dem Schritt c) und dem Schritt d) einen Schritt c1) der Aufbringung, insbesondere durch Laminierung, eines ersten Adhäsionsfilms (8) auf das Einfassungs-Substrat (100) und auf die wenigstens eine Probe (1) durch Adhäsion des ersten Adhäsionsfilms (8) jeweils auf die zweite Fläche (6) und auf die hintere Fläche (9).

9. Verfahren zur Verdünnung nach einem der Ansprüche 1 bis 8, in welchem das Einfassungs-Substrat (100) eine Dicke größer die der wenigstens einen Probe (1) aufweist, sodass nach dem Schritt der Verdünnung d) das Einfassungs-Substrat (100) eine Dicke größer als 150 Mikrometer aufweist.

10. Verdünnung nach einem der Ansprüche 1 bis 9, in welchem die zweite Fläche (6) des Einfassungs-Substrats (100) von der hinteren Fläche (9) der wenigstens einen Probe (1) hervorsteht.

11. Verfahren zur Verdünnung nach einem der Ansprüche 1 bis 10, in welchem der Schritt a) die Bereitstellung einer Vielzahl von Proben (1) umfasst, und
in welchem der Schritt b) die Bereitstellung eines Einfassungs-Substrats (100) umfasst, umfassend eine einmalige durchgehende Öffnung (7), in welcher die Vielzahl von Proben (1) in Schritt c) angeordnet wird, oder
in welchem der Schritt b) die Bereitstellung eines Einfassungs-Substrats (100) umfasst, umfassend eine Einheit von durchgehenden Öffnungen (7), und der Schritt c) die Anordnung jeder Probe (1) in einer entsprechenden durchgehenden Öffnung (7) umfasst.

12. Verfahren zur Verdünnung nach einem der Ansprüche 1 bis 11, in welchem der Schritt a) die Bereitstellung einer Vielzahl von Proben (1) umfasst und in welcher der Schritt c) die individuelle Anordnung jeder Probe (1) umfasst.

13. Verfahren zur Verdünnung nach einem der Ansprüche 1 bis 11, in welchem der Schritt a) die Bereitstellung einer Vielzahl von Proben (1) umfasst und in welchem der Schritt c) die kollektive Anordnung der Vielzahl von Proben (1) umfasst.

14. Verfahren zur Verdünnung nach Anspruch 13, in welchem der Schritt a) die folgenden Schritte umfasst:
i) Bereitstellen einer Platte, umfassend eine Vielzahl von Proben (1),
ii) Aufbringen eines zweiten Adhäsionsfilms (11) auf die Platte durch Laminierung,
iii) Schneiden der Platte, sodass die mit dem zweiten Adhäsionsfilm (11) solidarisierten Proben (1) individualisiert werden, und
in welchem der Schritt c) die folgenden Schritte umfasst:
iv) Übertragen des zweiten Adhäsionsfilms (11) auf das Einfassungs-Substrat (100), sodass die Vielzahl der Proben (1) kollektiv angeordnet wird, und
v) Abziehen des zweiten Adhäsionsfilms (11).

## Claims

1. A method for thinning samples (1) for applications in particular in the field of microelectronics, optoelectronics and power components, the method comprising the steps of:
a) Providing at least one sample (1) having a front face (3), a rear face (9) opposite to the front face (3) and flanks which extend between the front face (3) and the rear face (9),
b) Providing a frame substrate (100) having a first face (5) and a second face (6) opposite to the first face (5), the frame substrate (100) comprising a through-opening (7) which opens into the first face (5) and into the second face (6), the through-opening (7) being configured to receive the at least one sample (1),
c) Positioning the at least one sample (1) with respect to the frame substrate (100) so that the at least one sample (1) is disposed in the through-opening (7), the front face (3) being oriented to the same side as the first face (5), and
d) Thinning the frame substrate (100) and the at least one sample (1) simultaneously from the first face (5) and from the front face (3), respectively, so that at the end of thinning, the first face (5) of the frame substrate (100) and the front face (3) of the at least one sample (1) extend substantially in the same plane, the thinning being carried out by grinding using a grinder, the frame substrate (100) and the at least one sample (1) being disposed on a rotary disk and held in place by aspiration, the flanks of the at least one sample remaining free during the thinning operation.

2. The thinning method according to any of claims 1 to 2, **characterized in that** the positioning of the at least one sample (1) with respect to an adjacent sample (1) or with respect to the frame substrate (100) or with respect to a transverse wall (101) partitioning said frame substrate is carried out according to an interlayer distance D comprised between 10 micrometers and 3000 micrometers.

3. The thinning method according to claim 2, **characterized in that** the interlayer distance D is comprised between 10 micrometers and 50 micrometers.

4. The thinning method according to any of claims 1 to 3, wherein, prior to the thinning step d), the at least one sample (1) and the frame substrate (100) are configured so that the front face (3) of the at least one sample (1) protrudes from the first face (5) of the frame substrate (100) by a distance smaller than 100 micrometers, preferably smaller than 50 micrometers and still preferably a distance smaller than about 30 micrometers, and step d) comprises, prior to the simultaneous thinning of the frame substrate (100) and of the at least one sample (1), a step d1) of thinning of the at least one sample (1) alone.

5. The thinning method according to any of claims 1 to 4, wherein, prior to the thinning step d), the at least one sample (1) and the frame substrate (100) are configured so that the front face (3) of the at least one sample (1) is set back with respect to the first face (5) of the frame substrate (100) and in which step d) comprises, prior to the simultaneous thinning of the frame substrate (100) and of the at least one sample (1), a step d1) of thinning of the frame substrate (100) alone, and preferably, the at least one sample (1) and the frame substrate (100) are configured so that the front face (3) of the at least one sample (1) extends substantially in the plane of the first face (5) of the frame substrate (100).

6. The thinning method according to any of claims 1 to 5, comprising, after step d), at least one step e) of treating the at least one sample (1) disposed in the through-opening (7) of the frame substrate (100), such as a dry- or wet-etching step, a depositing step, a planarization step, a polishing step, a cleaning step, a step of encapsulation in electronic packages or a direct bonding step.

7. The thinning method according to any of claims 1 to 6, wherein the material of the at least one sample (1) and the material of the frame substrate (100) are selected among silicon, glass, sapphire, aluminum oxide, silicon carbide, germanium, niobium and lithium oxide LNO, lithium and titanium oxide LTO, the elements and the alloys of elements of columns IV, the elements and the alloys of elements of columns III and V, and the elements and the alloys of elements of columns II and VI, and preferably the material of the at least one sample (1) and the material of the frame substrate (100) are identical.

8. The thinning method according to any of claims 1 to 7, comprising between step c) and step d) a step c1) of setting up, in particular by rolling, a first adhesive film (8) on the frame substrate (100) and on the at least one sample (1) by adhesion of the first adhesive film (8) respectively on the second face (6) and on the rear face (9).

9. The thinning method according to any of claims 1 to 8, wherein the frame substrate (100) has a thickness greater than the thickness of the at least one sample (1) so that, after the thinning step d), the frame substrate (100) has a thickness greater than 150 micrometers.

10. The thinning method according to any of claims 1 to 9, wherein the second face (6) of the frame substrate (100) protrudes from the rear face (9) of the at least one sample (1).

11. The thinning method according to any of claims 1 to 10, wherein step a) comprises the provision of a plurality of samples (1), and
wherein step b) comprises the provision of a frame substrate (100) comprising one single through-opening (7) in which the plurality of samples (1) is disposed to step c), or
wherein step b) comprises the provision of a frame substrate (100) comprising a set of through-openings (7) and step c) comprises the disposition of each sample (1) in a respective through-opening (7).

12. The thinning method according to any of claims 1 to 11, wherein step a) comprises the provision of a plurality of samples (1) and wherein step c) comprises the individual disposition of each sample (1).

13. The thinning method according to any of claims 1 to 11, wherein step a) comprises the provision of a plurality of samples (1) and in which step c) comprises the collective disposition of the plurality of samples (1).

14. The thinning method according to claim 13, wherein step a) comprises the steps of:
i) Providing a plate comprising a plurality of samples (1),
ii) Setting up by rolling a second adhesive film (11) on the plate,
iii) Cutting the plate so as to individualize the samples (1) secured to the second adhesive film (11), and
wherein step c) comprises the steps of:
iv) Affixing the second adhesive film (11) on the frame substrate (100) so as to collectively dispose the plurality of samples (1), and
v) Removing the second adhesive film (11).
